# EUROPEAN PATENT SPECIFICATION

(11) **EP 3 655 563 B1**
(45) Date of publication and mention of the grant of the patent: **02.06.2021**
(21) Application number: 18739867.2
(22) Date of filing: 17.07.2018
(51) Int. Cl.: C23C 16/452, C23C 16/453, C23C 16/455, C23C 16/448, H05H 1/42, H05H 1/48, H01J 37/32, B01J 35/00, B82Y 30/00, G02B 27/00

(54) **PLASMA DEVICE FOR DEPOSITING A FUNCTIONAL COMPOSITE FILM COMPRISING CRYSTALLIZED PARTICLES EMBEDDED IN A MATRIX AND METHOD OF DEPOSITION THEREOF**
PLASMA-VORRICHTUNG ZUM ABSCHEIDEN VON EINER FUNKTIONELLEN VERBUNDFOLIE, DIE IN EINER MATRIX EINGEBETTETE KRISTALLISIERTE PARTIKEL ENTHÄLT, UND VERFAHREN ZU IHRER ABSCHEIDUNG
DISPOSITIF À PLASMA DESTINÉ À DÉPOSER UN FILM COMPOSITE FONCTIONNEL COMPRENANT DES PARTICULES CRISTALLISÉES INTÉGRÉES DANS UNE MATRICE, ET PROCÉDÉ DE DÉPÔT CORRESPONDANT

(30) Priority: 18.07.2017 LU 100335
(43) Date of publication of application: 27.05.2020
(73) Proprietor: Luxembourg Institute of Science and Technology (LIST), 4362 Esch-sur-Alzette (LU)
(72) Inventor: CHEMIN, Jean-Baptiste, 54190 Villerupt (FR); BULOU, Simon, 57070 Metz (FR); BOSCHER, Nicolas, 57390 Audun le Tiche (FR); CHOQUET, Patrick, 57050 Longeville les Metz (FR)
(74) Representative: Lecomte & Partners
(86) International application number: PCT/EP2018/069421
(87) International publication number: WO 2019/016221

(56) References cited:
- US-A1- 2010 304 143
- US-A1- 2013 084 236
- BOSCHER NICOLAS D ET AL: "Photocatalytic anatase titanium dioxide thin films deposition by an atmospheric pressure blown arc discharge", APPLIED SURFACE SCIENCE, vol. 311, 30 August 2014 (2014-08-30), pages 721-728, XP028875845, ISSN: 0169-4332, DOI: 10.1016/J.APSUSC.2014.05.145 cited in the application
- KAMAL BABA ET AL: "Photocatalytic Anatase TiO 2 Thin Films on Polymer Optical Fiber Using Atmospheric-Pressure Plasma", ACS APPLIED MATERIALS & INTERFACES, vol. 9, no. 15, 6 April 2017 (2017-04-06), pages 13733-13741, XP055462953, US ISSN: 1944-8244, DOI: 10.1021/acsami.7b01398
- Jacopo Profili: "Dépôt de couches minces nanocomposites par nébulisation d'une suspension colloïdale dans une décharge de Townsend à la pression atmosphérique", THÈSE en vue de l'obtention du DOCTORAT DE L'UNIVERSITÉ DE TOULOUSE, 30 August 2016 (2016-08-30), pages 1-249, XP055463340, France Retrieved from the Internet: URL:http://thesesups.ups-tlse.fr/3194/1/20 16TOU30131.pdf [retrieved on 2018-03-27]

## Description

### Technical field

The invention is directed to the field of surface treatment, particularly on a device and a method for depositing a composite functional film on a substrate.

### Background art

Prior art published scientific paper Tricoli, A. et al. (2009). "Anti-fogging nanofibrous SiO2 and nanostructured SiO2-TiO2 films made by rapid flame deposition and in situ annealing". Langmuir, 25:12578-12584, discloses a method for depositing antifogging and self-cleaning SiO₂-TiO₂ thin film on a substrate. The method of deposition is performed by flame spray pyrolysis of organometallic solution and by stabilization of the coating by in situ flame annealing. TiO₂ precursors are injected in the flame. During deposition, the burner is at a distance of 20 cm of the substrate and reaches a maximum temperature of 550°C ± 20°C. The method of deposition is unsuitable for coating functional thin composite film comprising crystalline metal oxide particles on heat-sensitive substrates.

Prior art published scientific paper Boscher, N. et al. (2014). "Photocatalytic Anatase titanium dioxide thin films deposition by an atmospheric pressure blown arc discharge". Applied Surface Science, 311, 721-728, discloses a method for depositing photocatalytic anatase titanium thin films on a substrate by atmospheric pressure blown arc discharge. The deposition is performed by passing the TiO₂ precursor in the plasma torch downstream. However, the device and the method are not adapted to deposit, on heat-sensitive substrates, composite functional films of good quality comprising metal oxide crystalline particles Prior art published scientific paper Kamal, B et al. (2017). "Photocatalytic Anatase TiO2 Thin Films on Polymer Optical Fiber Using Atmospheric-Pressure Plasma". ACS Applied Materials and Interfaces, Vol. 9, No. 15, discloses a method for depositing photocatalytic anatase TiO₂ thin films at a low temperature on polymer optical fibers using an atmospheric-pressure plasma process. The films deposited when oxygen is present in the carrier gas exhibit a better photocatalytic activity.

### Summary of invention

### Technical Problem

The invention has for technical problem to provide a solution that overcome at least one drawback of the mentioned prior art. Particularly, the invention has for technical problem to provide a device and a method for one-step and low-temperature deposition of a thin functional composite film on heat-sensitive and non-heat-sensitive substrates, at atmospheric pressure.

### Technical solution

The invention is directed to a plasma device, as defined in claim 1, for depositing a functional composite film on a substrate at atmospheric pressure, said device comprising a conduit extending along a longitudinal axis with a gas inlet; a discharge area configured to electrically excite the gas in the conduit at the inlet in order to produce a plasma at atmospheric pressure; a post-discharge area downstream of the discharge area, comprising at least one first inlet through a wall of the conduit, for injecting a first precursor or precursors mixture in the plasma; a plasma outlet; wherein the post-discharge area further comprises at least one second inlet through the wall of the conduit, for injecting a second precursor or precursors mixture in the plasma downstream of the at least first inlet.

According to a preferred embodiment, the at least one first inlet is located, along the longitudinal axis, at a distance b of the discharge area, said distance b being comprised between 0 mm and 15 mm, preferably inferior to 5 mm.

According to a preferred embodiment, the at least one first inlet and the at least one second inlet are separated from each other, along the longitudinal axis, with a distance a comprised between 5 mm and 150 mm, preferably between 5 mm and 50 mm.

According to a preferred embodiment, the device is configured to produce a discharge power density superior or equal to 10 W/cm².

According to a preferred embodiment, the device is supported by a movable support.

According to a preferred embodiment, each of the at least one first inlet and the at least one second inlet are respectively configured to inject the first and the second precursor or precursors mixtures into a mist and/or aerosol and/or vapour in the post-discharge area.

According to a preferred embodiment, said substrate is a heat-sensitive substrate

According to a preferred embodiment said substrate is a one-dimensional, a two-dimensional substrate or a three-dimensional substrate.

The invention is also directed to a plasma-enhanced chemical vapour deposition method, as defined in claim 7, for depositing a functional composite film on a substrate, said method comprising the steps of: producing a plasma with a plasma device; injecting a first precursor or precursors mixture in a post-discharge area of said plasma device; wherein the method further comprises a step of injecting a second precursor or precursors mixture in said post-discharge area of said plasma device, simultaneously to the step of injecting a first precursor or precursors mixture and downstream to the first injection, said plasma device being in accordance with the invention.

According to a preferred embodiment, said first precursor or precursors mixture comprises a metal oxide precursor and said second precursor or precursors mixture comprises a matrix precursor.

According to a preferred embodiment, the first precursors mixture further comprises at least one metal oxide doping precursor.

According to a preferred embodiment, in steps of injecting a first precursor or precursors mixture and a second precursor or precursors mixture, the first precursor or precursors mixture and the second precursor or precursors mixture are injected at a flow speed comprised between 1 and 1000 µL/min.

According to a preferred embodiment, in each of the steps of injecting a first precursor or precursors mixture and a second precursor or precursors mixture, said precursors or precursors mixtures are injected with a gas carrier, preferably N₂.

According to a preferred embodiment, the gas carrier is injected at a flow speed comprised between 0.5 and 20 L/min for the first and the second precursor or precursor mixtures.

According to a preferred embodiment, during deposition, the at least one second inlet is placed, along the longitudinal axis, at a distance c of the substrate to be coated which is comprised between 1 mm and 150 mm.

According to a preferred embodiment, during deposition, the device moves in relation to the substrate.

According to a preferred embodiment, in step of producing a plasma, a gas is introduced in the gas inlet at a flow speed comprised between 10 and 100 L/min.

According to a preferred embodiment, the gas introduced in the gas inlet is selected from the group consisting of: Argon, Nitrogen, a mixture of Argon with maximum 20% of Oxygen, a mixture of Nitrogen with maximum 20% of Oxygen or compressed air.

According to a preferred embodiment, the deposition is carried out at an atmospheric pressure and/or at a substrate temperature comprised between 50 °C and 500°C.

According to a preferred embodiment, the first precursor or precursors mixture comprises a TiO₂ precursor or a V₂O₅ precursor and/or the second precursor or precursors mixture comprises a SiO₂ precursor.

According to a preferred embodiment, the TiO₂ precursor is selected from the group consisting : titanium isopropoxide, titanium tetrachloride, titanium butoxide, titanium diisopropoxide bis (acetylacetonate) and titanium ethoxide and the SiO₂ precursor is selected from the group consisting of hexamethyldisiloxane, hexamethylcyclotrisiloxane, octamethylcyclotetrasiloxane, decamethylcyclopentasiloxane, dodecamethylcyclohexasiloxane, hexaethyldisiloxane, tetraethylorthosilicate, aminopropyl-trimethoxysilane, tetramethyldisiloxane, pentamethylcyclopentasiloxane, octamethylcyclooctasiloxane, vinyltrimethoxysilane, trimethoxypropylsilane, preferably hexamethyldisiloxane.

### Advantages of the invention

The invention is particularly interesting in that the device and the method of the invention allows a one-step deposition, at low-temperature, of a functional composite film comprising metal oxide crystalline particles embedded in a matrix. The invention is particularly interesting for depositing functional composite film on heat-sensitive substrates, such as polymers, plastics and/or glass without deteriorating said substrates, while providing a coating of good quality. The invention allows the simultaneous synthesis of metal oxide crystalline particles and their embedding into a matrix deposited with a low substrate temperature thanks to spatially separated, but simultaneously, operated injections of two precursors or precursors mixtures into the stream of the post-discharge area of the plasma device.

### Brief description of the drawings

Figure 1 is a schematic representation of a plasma device in accordance with the invention.
Figure 2: Raman spectrum of TiO₂/SiO₂ thin film on a PEN substrate.
Figure 3a-3d: SEM images of the TiO₂/SiO₂ thin film elaborated from various HMDSO delivery rates.
Figure 4a: Graphic of the growth rate ratio of the deposited film as a function of the content of silicon in the film.
Figure 4b: Graphic of Si/(Si/Ti) ratio of the deposited film as a function of various HMDSO delivery rates.
Figure 5a: XPS analysis of titanium environment.
Figure 5b: XPS analysis of silicon environment.
Figure 6a: Photocatalytic activity of anatase TiO₂/SiO₂ coatings as function of the Si/(Si/Ti) ratio before and after immersion in an ultrasonic bath.
Figure 6b: Graphic of the water contact angle of the deposited film as a function of the Si/(Si/Ti) ratio.

### Description of an embodiment

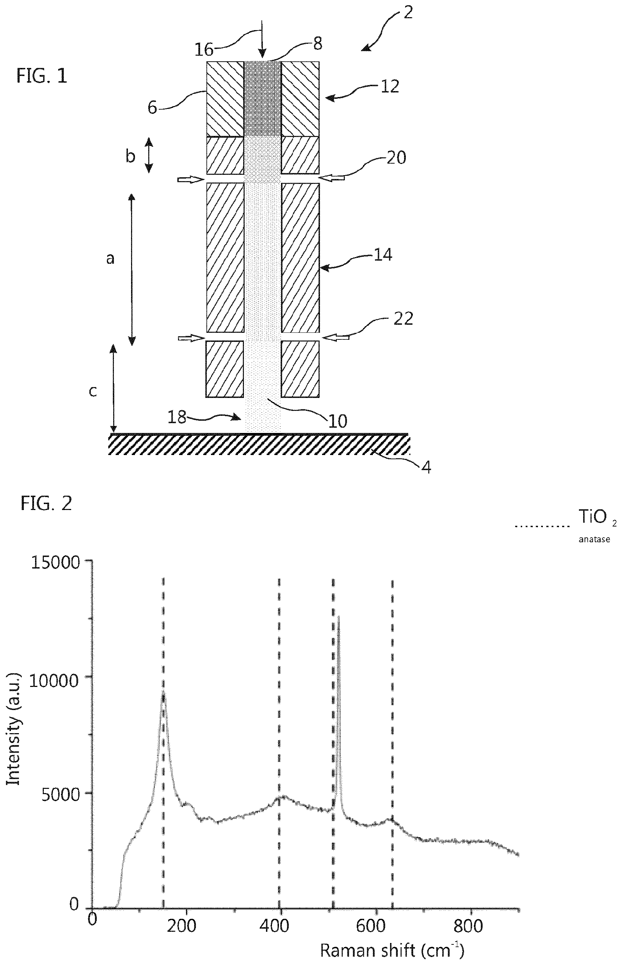

Figure 1 illustrates a plasma device 2 for depositing a functional film on a substrate in accordance with the invention. Particularly, the plasma device 2 is configured to deposit a functional and thin composite film comprising metal oxide crystallized particles on a substrate 4, especially on a heat-sensitive substrate.

The plasma device 2 comprises a conduit 6 extending along a longitudinal axis. The conduit has preferably a tubular shape. The conduit comprises a gas inlet 8 and a plasma outlet 10. The conduit 6 of the device also comprises a discharge area or portion 12 configured to electrically excite the gas so as to produce a plasma at atmospheric pressure. The discharge area 12 can comprise electric means configured to excite the gas. More precisely, the discharge area 12 can comprise two electrodes (not represented) configured to produce an electrical arc when supplying said electrodes with an electrical power source, the discharge area extending approximatively along said electrodes. The gas used to produce the plasma is a plasmagenic gas or non-condensable gas, preferably N₂. Preferably, the gas is injected in the gas inlet 8 at a flow speed comprised between 10 and 100 L/min.

The conduit 6 of the plasma device 2 also comprises a post-discharge area or portion 14 downstream of the discharge area 12 and adjacent to the discharge area 12. The plasma is configured to flow axially from the discharge area 12 through the post-discharge area 14 in a working direction 16, toward the plasma outlet 10 in a coating area 18. The post-discharge area of the plasma device 2 comprises at least one first inlet 20 through a wall of the conduit, for injecting a first precursor or precursors mixture in the plasma. The first inlet 20 or each first inlet 20 is configured to inject a first precursor or precursors mixture in the post-discharge area 14, in the working direction 16. The post-discharge area 14 of the device of the invention further comprises at least one second inlet 22 on the wall of the conduit, for injecting a second precursor or precursors mixture in the plasma downstream of the at least one first inlet 20. The second precursor or precursors mixture is injected in the post-discharge area 14 in the working direction 16. The at least one second inlet 22 is located, along the longitudinal axis, between the at least one first inlet 20 of a first precursor or precursors mixture and the plasma outlet 10.

The first precursor or precursors mixture comprises a metal oxide precursor. The first precursors mixture can further comprise at least one metal oxide doping precursor.

The second precursor or precursors mixture comprises a matrix precursor. The term matrix precursor refers herein to any chemical precursor suitable for forming a matrix.

Metal oxide doping precursor refers herein to any chemical precursor suitable for the doping of the metal oxide material. The choice of the doping precursor will be made according the expected properties of the composite film.

Each of the at least one first inlet 20 and the at least one second inlet 22 is transversally to the longitudinal axis of the plasma device. The plasma device 2 can comprise several first inlets 20 and several second inlets 22, localised around the conduit 6 of the plasma device, in the post-discharge area 14. As represented in figure 1, the plasma device 2 can comprise, for example, two opposed first inlets 20 and two opposed second inlets 22, represented by an arrow.

Each of the at least one first inlet 20 and the at least one second inlet 22 is respectively configured to inject the first and the second precursors or precursors mixtures, respectively, into a mist and/or aerosol and/or vapour in the post-discharge area 14.

The at least one first inlet and the at least one second inlet are preferably ultrasonic nozzles. Ultrasonic nebulization nozzles Sono-Tek Corporation ™ can be used at a frequency of 120 kHz and a power of 2 W.

In case of one first inlet and one second inlet, each inlet extends preferably circumferentially around the conduit, in the post-discharge area in order to inject each precursor or precursors mixture homogeneously in the post-discharge area 14.

As illustrated in figure 1, the plasma device 2 comprises two opposed first inlets 20 and two opposed second inlets 22, the number of inlets does not limit the invention. The first inlets 20 and the second inlets 22 are separated from each other, along the longitudinal axis, with a distance a comprised between 5 mm and 150 mm, preferably between 5 mm and 50 mm.

Each first inlet 20 is located at a distance b of the discharge area 12, said distance b being comprised between 0 mm and 15 mm, preferably inferior to 5 mm, more preferably between 1 and 3 mm, along the longitudinal axis. More precisely, each first inlet is located at a distance b of the end of the discharge area, said end being opposed to the gas inlet 8.

Thefirst and the second precursor or precursors mixtures are injected in the post-discharge area with a gas carrier, preferably N₂.

The first and the second precursor or precursors mixtures are preferably injected in the post-discharge area in the form of droplets with a droplet's diameter comprises preferably between 10 and 20 µm. According to a preferred embodiment, the first precursor or precursors mixture is heated to 90°C during injection in the post-discharge area.

The device is configured to produce a discharge power density superior or equal to 10 W/cm². The discharge power density allows the formation of crystalline metal oxide particles and a solid matrix.

The first precursor or precursors mixture is thus injected at the nearest position of the discharge area 12. The injection of the first precursor or precursors mixture in this part of the post-discharge area 14 promotes the formation of crystalline metal oxide particles thanks to the high density of reactive species and the relatively high gas temperature in said part. In order to optimize the production of crystalline nanoparticles, the first precursor or precursors mixture is injected in the post-discharge area of the plasma device with a flow speed which is comprised between 1 and 1000 µL·min^{-1.}

On the other hand, the second precursor or precursors mixture is simultaneously injected in a lower part of the plasma stream in the post-discharge area and preferably close to the substrate to coat, in order to promote heterogeneous chemical reactions at the substrate surface and consequently, the growth of a matrix layer embedding the crystalline nanoparticles formed above. The second precursor or precursors mixture is preferably injected in the post-discharge area at a flow speed comprised between 1 and 1000 µL/min. According to a preferred embodiment, during deposition or the coating, the at least one second inlet 22 is placed at a distance c of the substrate 4 to be coated, said distance c being comprised between 1 mm and 150 mm, along the longitudinal axis. The short distance between the at least one second inlet 22 and the substrate allows a dense coating on said substrate.

Advantageously, the device is supported by a moveable support (not represented). During deposition or the coating, the device moves in relation to the substrate in order to facilitate the coating of the substrate.

According to a preferred embodiment of the invention, the gas carrier is injected at a flow speed comprised between 0.5 and 20 L/min for the first and the second precursors or precursors mixtures.

The deposition is carried out at atmospheric pressure and/or at a substrate temperature comprised between 50 °C and 550°C.

As an example, the metal oxide precursor is a titanium dioxide (TiO₂) precursor in order to synthetize anatase TiO₂, known as having photocatalytic properties.

The TiO₂ precursor can be selected from a group consisting, but not limited to, titanium isopropoxide (TTIP), titanium tetrachloride, titanium butoxide, titanium diisopropoxide bis (acetylacetonate) and titanium ethoxide, preferably titanium isopropoxide. The synthetized particles of TiO₂ contain a large part of crystalline anatase TiO₂ phase.

As another example, the metal oxide precursor can be a vanadium pentoxide (V₂O₅) precursor or a vanadium dioxide (VO₂) precursor, which will provide photochromic properties to the composite film.

The V₂O₅ and/or VO₂ precursor can be selected from a group consisting, but not limited to, vanadium oxychloride (VOCl₃), vanadyl acetylacetonate (C₁₀H₁₄O₅V), vanadium tetrakisdimethylamide (V(NMe₂)₄) and vanadium tetrachloride (VCl₄). The synthetized particles of V₂O₅ contain a large part of crystalline V₂O₅ and/or VO₂ phase.

As other example, the metal oxide precursor can be a tungsten trioxide (WO₃) precursor, which will provide electrochromic properties to the composite film. WO₃ is also known for photocatalytic water splitting applications.

The WO₃ precursor can be selected from a group consisting, but not limited to, tungsten ethoxide (W(OEt)₆) and tungsten hexachloride (WCl₆). The synthetized particles of WO₃ contain a large part of crystalline WO₃ phase.

As other examples, the metal oxide can be a zinc oxide (ZnO) precursor or a ceric oxide (CeO₂) precursor or an indium oxide (In₂O₃) precursor or a zirconium dioxide (ZrO₂) precursor.

Moreover, the first precursors mixture can also comprise metal and/or non-metal dopant precursors.

In case of TiO₂, the anatase titanium dioxide particles can be doped in order to enhance their photocatalytic properties and/or to expand the photocatalytic activity of anatase TiO₂ to the visible-light region of the solar spectrum.

Non-metal, such as boron, nitrogen, carbon, phosphorus or sulphur, and metal elements, such as tungsten, vanadium, chromium, iron, silver, niobium or nickel have been proved to be effective dopants for TiO₂.

Suitable precursors for the doping of anatase TiO₂ with boron (B-TiO₂) include triethyl borate ((C₂H₅O)₃B), trimethyl borate (B(OCH₃)₃ and boric acid (H₃BO₃).

Suitable precursors for the doping of anatase TiO₂ with nitrogen (N-TiO₂) include NH₃. An alternative is the injection of a small amount of nitrogen gas to the plasma gas or to the titanium precursor carrier gas.

Suitable precursors for the doping of anatase TiO₂ with sulfur (S-TiO₂) include thiourea (CH₄N₂S).

Suitable precursors for the doping of anatase TiO₂ with carbon (C-TiO₂) include ethanol and sucrose (C₁₂H₂₂O₁₁).

Suitable precursors for the doping of anatase TiO₂ with phosphorus (P-TiO2) include triethyl phosphate [(C₂H₅O)₃PO].

Suitable precursors for the doping of anatase TiO₂ with tungsten (W-TiO₂) include tungsten ethoxide [W(OEt)₆].

Suitable precursors for the doping of anatase TiO₂ with vanadium (V-TiO₂) include vanadium tetrachloride (VCl₄) and vanadyl acetylacetonate [C₁₀H₁₄O₅V].

Suitable precursors for the doping of anatase TiO₂ with chromium (Cr-TiO₂) include chromium nitrate [Cr(NO₃)₃].

Suitable precursors for the doping of anatase TiO₂ with iron (Fe-TiO₂) include ferrous nitrate [Fe(NO₃)₃].

Suitable precursors for the doping of anatase TiO₂ with silver (Ag-Ti_{O2}) include silver nitrate (AgNOs).

Suitable precursors for the doping of anatase TiO₂ with nickel (Ni-TiO₂) include nickel nitrate [Ni(NO₃)₂].

Suitable precursors for the doping of anatase TiO₂ with Nb (Nb-TiO₂) include nickel nitrate Nb ethoxide [Nb(OEt)₅].

In case of V₂O₅ and/or VO₂, the crystalline vanadium oxide particles can be doped in order to tune their photochromic properties.

Non-metal, such as fluorine or magnesium, and metal elements, such as tungsten, molybdenum, zirconium, hafnium or titanium have been proved to be effective dopants for V₂O₅ and VO₂.

In case of WO₃, the crystalline tungsten oxide particles can be doped in order to tune their electrochromic properties or enhance their photocatalytic water splitting performances.

Non-metal, such as nitrogen, and metal elements, such as iron, cobalt, nickel, copper, niobium, molybdenum or zinc have been proved to be effective dopants for WO₃.

As an example, the matrix precursor is a SiO₂ precursor selected from a group consisting, but not limited to, hexamethyldisiloxane (HDSMO), hexamethylcyclotrisiloxane, octamethylcyclotetrasiloxane, hexamethylcyclotrisiloxane, decamethylcyclopentasiloxane, dodecamethylcyclohexasiloxane, hexaethyldisiloxane, tetraethylorthosilicate, aminopropyl-trimethoxysilane, tetramethyldisiloxane, pentamethylcyclopentasiloxane, octamethylcycloocta siloxane, vinyltrimethoxysilane and trimethoxypropylsilane, preferably hexamethyldisiloxane. The SiO₂ precursor will provide anti-fog properties to the functional composite film.

As an example, the matrix precursor is an organic precursor, preferably comprising at least one polymerizable bond, including unsaturated groups such as allyl, vinyl, acrylic or ethynyl groups or a cyclic structure.

Experimental tests have been done in order to deposit a thin functional composite film comprising crystalline particles, with the device and method of the invention. A TiO₂ precursor and more particularly titanium tetraisopropoxide (TTIP, Sigma Aldrich™, 98 %) was used as the first precursor and a SiO₂ precursor, more particularly hexamethyldisiloxane (HMDSO, Sigma Aldrich™, 98 %), was used as the second precursor.

The experimental results are shown on figure 2 to figure 6b.

N₂ was used as a gas carrier. The gas carrier was injected, for the TiO₂ precursor, at a flow speed comprised between 5 and 7 µL/min, preferably between 2 and 4 µL/min, more preferably 3 µL/min. For the SiO₂ precursor, the gas carrier is injected at a flow speed comprised between 2 and 10 µL/min, preferably between 4 and 6 µL/min, more preferably 5 µL/min.

N₂ was used to produce the plasma and was injected in the plasma device at a flow speed comprised between 10 and 100 L/min.

Figure 2 represents a Raman spectroscopy analysis of an anatase TiO₂/SiO₂ nanocomposite coating or film elaborated from a 2µL/min HDSMSO delivery rate on a PEN substrate. The Raman spectra were recorded with a Renishaw inVia™ micro-Raman spectrometer at an excitation wavelength of 532 nm with a laser power of approximately 2.5 mW focused on a 5 µm² spot. The results highlight the presence of numerous particles. Most of these particles were composed of anatase TiO₂ such as highlighted with the presence of bands at 144, 197, 399 and 640 cm⁻¹. No rutile TiO₂ and nor other phase was detected.

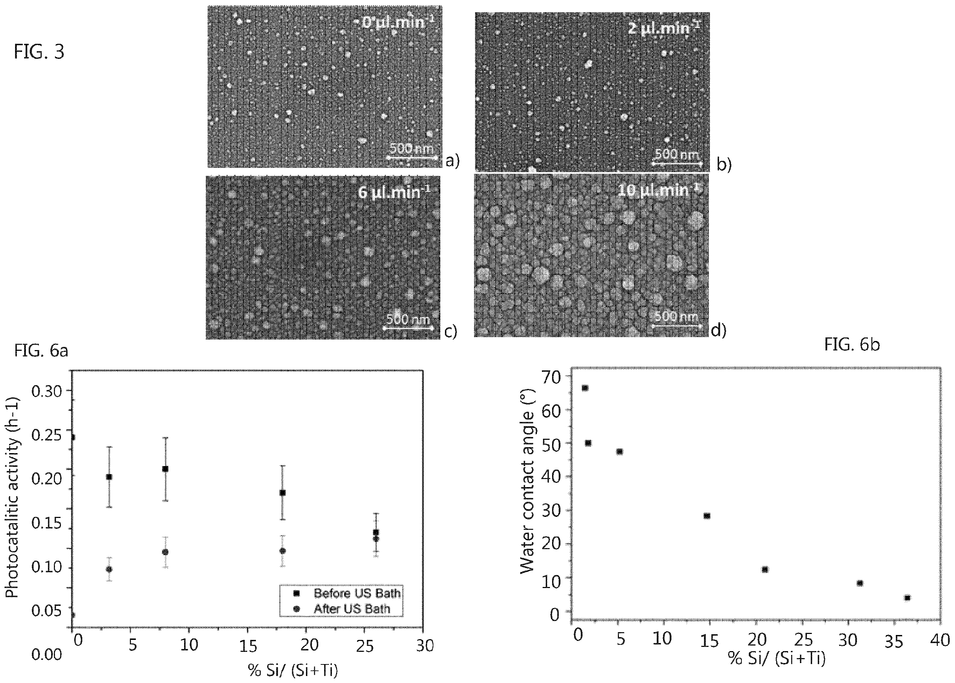

Figures 3a to 3d show SEM observations of TiO₂/SiO₂ coating deposited on a substrate performed with HDMSO flow varying from 0 to 10 µL/min.

The morphology of the coatings was observed by Scanning Electron Micorscope Hitachi™ U70 at a magnification of 50,000. To avoid any charging effect of the electron beam, the samples were preliminary coated with a platinum thin film of ca. 5 nm by magnetron sputtering deposition

Figure 3a shows the SEM analysis of a film deposited without HMDSO. The analysis reveals a film structure composed of grains with size ranging from 10 to 50 nm, all over the surface and the presence of few nanograins agglomeration. Up to a 2 µL/min HMDSO delivery rate (figure 3 b), the morphology of the deposited coatings was not significantly different from the one grown without addition of HMDSO. Further increase of the HMDSO delivery rate slowly led to a conversion of the microstructure of the films toward cauliflower morphology (Figure 3c and 3d). SEM observations confirmed that the films deposited with the device and method of the invention are dense, homogeneous and with a complete coverage of the substrate surface.

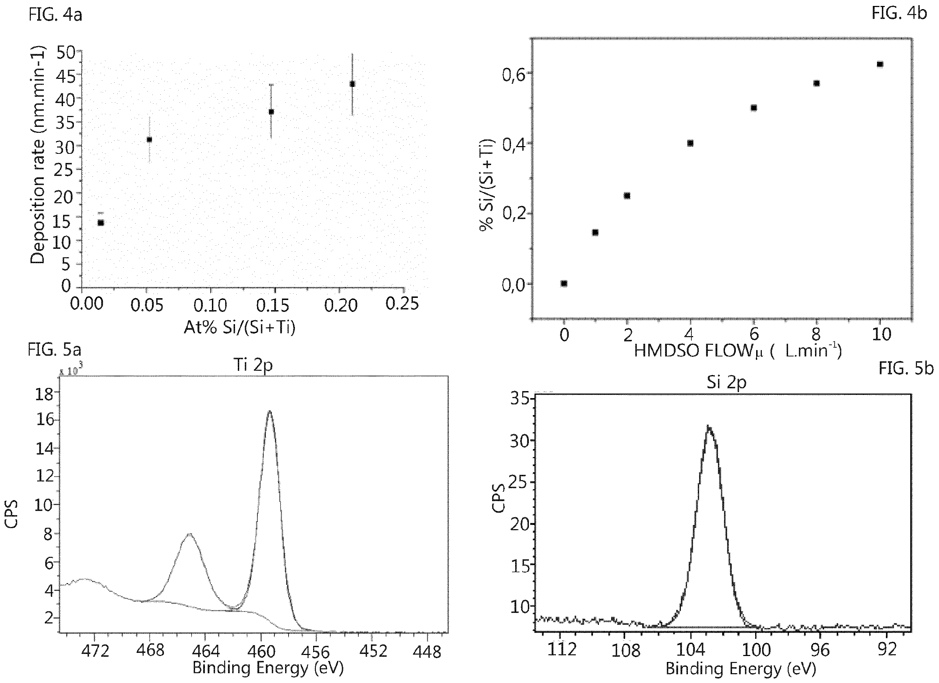

Figure 4a represents a graphic of the deposition rate of the films as a function of the silicon content in the film.

Figure 4b represents the evolution of the ratio of the silicon content over the total amount of silicon and titanium (Si/(Si+Ti)) as a function of the HMDSO delivery rate from 0 to 10 µL·min⁻¹. The silicon concentration of the films increases while adding a more important flow of HMDSO into the post-discharge area. The ratio of the silicon content over the total amount of silicon and titanium (Si/(Si+Ti) increased linearly from 0 to 60 % when increasing the HMDSO delivery rate from 0 to 10 µL·min⁻¹, respectively.

Figure 5a and 5b respectively shows the XPS analysis of the titanium environment and the XPS analysis of the silicon environment in the deposited film. XPS analyses were performed on a Kratos™ Axis Ultra DLD instrument using a monochromatic Al Kα X-ray source (hv = 1486.6 eV) at pass energy of 20 eV for high resolution spectra. Argon sputtered cleaning at 3 keV and 2 mA was used for approximately 500 s in a scanning mode in order to clean the surface and to get the most representative information on the coating elemental composition in the film.

Irrespective of the deposition conditions, the positions of the Ti 2p_{1/2} and Ti 2p_{3/2} peaks, observed at 464.4 eV and 458.7 eV, respectively indicate the formation of TiO₂ (Figure 5a). The high-resolution Si 2p core level (Si 2p_{1/2} and Si 2p_{3/2}) was measured at 103.4 eV with a full width at half maximum (FWHM) of 2.2 eV, suggesting the formation of SiO₂ (Figure 5b). No evidence of SiTiOₓ bonding is observed. This contrasts with results obtained during preliminary experiments of this work, which only allowed to form a single SiTiOₓ phase when injecting the TTIP and HMDSO precursors in the same area of the plasma post-discharge (not shown). Thus, a separated injection of the TTIP and HMDSO precursors, in accordance with the invention, is necessary to generate a two-phase's structure with crystalline TiO₂ phase separated from the silicon oxide phase. The prepared films are anatase TiO₂/SiO₂ nanocomposites coatings.

The photocatalytic activity of the anatase TiO₂/SiO₂ nanocomposite coatings under UV (ultraviolet) light was assessed for each of the prepared coatings, before and after immersion in an ultrasonic bath (at 7 hours). The photocatalytic activity measurements were done with coatings deposited on a double side polished undoped silicon wafer. 5 µl of steric acid diluted at 0.05 M in methanol was deposited on the coated wafer using a spin coater rotating at 1,000 rpm during 30 s. Afterward, the sample was placed into a box at a distance of 20 cm from an 8 W UV light with a wavelength of 254 nm. The kinetic degradation of the steric acid was followed by analysis using Fourier transform infrared spectroscopy (FTIR) in transmission mode thanks to the decrease of the CH₂-CH₃ absorption band in the range 2,800-3,000 cm⁻¹ as a function of illumination duration. The results are represented in Figure 6a.

The highest acid stearic degradation rate, *i.e.* 0.24 h⁻¹, was measured for the pure TiO₂ coating ([HMDSO] = 0 µL·min⁻¹). Incorporation of HMDSO into the post-discharge only led to a decrease of the photocatalytic activity down to 0.12 h⁻¹. It is interesting to note that the photocatalytic activity of the anatase TiO₂/SiO₂ nanocomposite coatings never decreased below 50 % of the one of the pure TiO₂ sample. More interestingly, after 7 hours immersion in an ultrasonic bath, the acid stearic degradation rate of sample elaborated from the highest HMDSO delivery rate remained unchanged, *i.e.* 0.12 h⁻¹. This contrasts with photocatalytic activity of all the others samples, which was reduced in various proportions. While the degradation rate of samples was reduced from 0.2 h⁻¹ to 0.1 h⁻¹ (*i.e.* -50 %) for the sample deposited with a 6 µL·min⁻¹, it was reduced from 0.24 h⁻¹ to 0.02 h⁻¹ (*i.e.* -83 %) for the pure TiO₂ sample. This results clearly highlights the benefit of the proposed nanocomposite approach, which allows to maintain a good photocatalytic activity that remain unaltered even after sonication for 7 hours. Also, on the growth layer mechanism study, this result clearly shows that the anatase TiO₂ is mostly synthesized by gas homogeneous reactions that produced crystallize clusters on the surface. The simultaneous growing of a silica layer makes possible their embedment and the synthesis of a mechanical resistant nanocomposite TiO₂/SiO₂ coating.

Figure 6b shows the evolution of the water contact angle (WCA) as a function of the content of silicon in the film which is related to the HDMSO precursor flow (Figure 4b). The WCA measurements and the pictures of the droplets (not shown) were obtained using a Kruss™ DSA16 EasyDrop USB contact angle meter. The volume of the de-ionized water drop used for the measurements was 3 µL.

In addition to afford a better mechanical stability to the deposited films, addition of the HMDSO precursor is inducing a lowering of the water contact angle of the as-deposited films. While the WCA of the pure TiO₂ coating was evaluated to 66°, WCA as low as 5° was measured for the film with the highest content of silicon. This superhydrophilic behavior is assumed to benefit to the observed photocatalytic properties thanks to a better wetting of the surface of the TiO₂/SiO₂ nanocomposite coating and the subsequent photocatalytic degradation ensure by the anatase TiO₂ moiety.

The simultaneous but spatially separated injections of two precursors or precursors mixtures into the stream of the post-discharge area provide a solution towards the deposition of functional nanocomposite coatings comprising crystallized nanoparticles on both 2D and 3D substrates. In contrast with thermal CVD approaches, the particles are synthesized, more precisely crystallized, remotely from the substrate's surface, making the developed method suitable for the coating of heat-sensitive substrates such as, but not limited to, polymers, glass, metal etc... The consecutive immobilization of the crystallized nanoparticles into a matrix is ensuring the mechanical stability of the resulting nanocomposite coatings. In case of anatase TiO₂-SiO₂ film, the photocatalytic activity of the anatase TiO₂/SiO₂ nanocomposite coatings, albeit lower than for the pure TiO₂ coating (*i.e.* -50 %), is still significant and more importantly is fully retained even after prolonged sonication. It is also interesting to note that the photocatalytic, superhydrophilic and adherent nanocomposite coatings are also optically transparent (not shown).

The method and the device of the invention are particularly interesting in that the in-situ synthesis and deposition of nanoparticles in the same process is allowing to avoid any handling of these potentially harmful materials The invention is defined by the claims.

## Claims

1. Plasma device (2) for depositing a functional composite film on a substrate (4) at atmospheric pressure, said plasma device comprising a conduit (6) extending along a longitudinal axis with:
- a gas inlet (8);
- a discharge area (12) configured to electrically excite the gas in the conduit (6) at the gas inlet (8) in order to produce a plasma at atmospheric pressure;
- a post-discharge area (14) downstream of the discharge area (12), comprising at least one first inlet (20) through a wall of the conduit, for injecting a first precursor or precursors mixture in the plasma;
- a plasma outlet (10);
wherein the post-discharge area (14) further comprises at least one second inlet (22) through the wall of the conduit, for injecting a second precursor or precursors mixture in the plasma downstream of the at least first inlet (20).

2. Plasma device (2) according to claim 1, wherein the at least one first inlet (20) is located, along the longitudinal axis, at a distance b of the discharge area (12), said distance b being comprised between 0 mm and 15 mm, preferably inferior to 5 mm.

3. Plasma device (2) according to any one of claims 1 and 2, wherein the at least one first inlet (20) and the at least one second inlet (22) are separated from each other, along the longitudinal axis, with a distance a comprised between 5 mm and 150 mm, preferably between 5 mm and 50 mm.

4. Plasma device (2) according to any one of claims 1 to 3, wherein said device is configured to produce a discharge power density superior or equal to 10 W/cm².

5. Plasma device (2) according to any one of claims 1 to 4, wherein said plasma device is supported by a movable support.

6. Plasma device (2) according to any one of claims 1 to 5, wherein each of the at least one first inlet (20) and the at least one second inlet (22) are respectively configured to inject the first and the second precursors or precursors mixtures into a mist and/or aerosol and/or vapour in the post-discharge area.

7. Plasma-enhanced chemical vapour deposition method for depositing a functional composite film on a substrate (4), said method comprising the steps of:
- producing a plasma with a plasma device (2)
- injecting a first precursor or precursors mixture in a post-discharge area (14) of said plasma device (2);
wherein the method further comprises a step of injecting a second precursor or precursors mixture in said post-discharge area (14) of said plasma device, simultaneously to the step of injecting a first precursor or precursors mixture and downstream to the first injection, said plasma device (2) being in accordance with any one of claims 1 to 6.

8. Method according to claim 7, wherein said first precursor or precursors mixture comprises a metal oxide precursor and in that said second precursor or precursors mixture comprises a matrix precursor, and preferably wherein the first precursors mixture further comprises at least one metal oxide doping precursor.

9. Method according to one of claims 7 and 8, wherein, in steps of injecting a first precursor or precursors mixture and a second precursor or precursors mixture, the first precursor or precursors mixture and the second precursor or precursors mixture are injected at a flow speed comprised between 1 and 1000 µL/min.

10. Method according to any one of claims 7 to 9, wherein in each of the steps of injecting a first precursor or precursors mixture and a second precursor or precursors mixture, said precursors or precursors mixtures are injected with a gas carrier, preferably N₂, and preferably wherein the gas carrier is injected at a flow speed comprised between 0.5 and 20 L/min for the first and the second precursor or precursor mixtures.

11. Method according to any one of claims 7 to 10, wherein, during deposition, the at least one second inlet (22) is placed, along the longitudinal axis, at a distance c of the substrate (4) to be coat which is comprised between 1 mm and 150 mm.

12. Method according to any one of claims 7 to 11, wherein during deposition, the plasma device (2) moves in relation to the substrate (4).

13. Method according to any one of claims 7 to 12, wherein, in step of producing a plasma, a gas is introduced in the gas inlet (8) at a flow speed comprised between 10 and 100 L/min, preferably wherein the gas introduced in the gas inlet (8) is selected from the group consisting of: Argon, Nitrogen, a mixture of Argon with maximum 20% of Oxygen, a mixture of Nitrogen with maximum 20% of Oxygen or compressed air.

14. Method according to any one of claims 7 to 13, wherein the deposition is carried out at an atmospheric pressure and/or at a substrate temperature comprised between 50 °C and 500°C.

15. Method according to any of claims 7 to 14, wherein the first precursor or precursors mixture comprises a TiO₂ precursor or a V₂O₅ precursor and/or the second precursor or precursors mixture comprises a SᵢO₂ precursor, and preferably wherein the TiO₂ precursor is selected from the group consisting : titanium isopropoxide, titanium tetrachloride, titanium butoxide, titanium diisopropoxide bis (acetylacetonate) and titanium ethoxide and the SiO2 precursor is selected from the group consisting of hexamethyldisiloxane, hexamethylcyclotrisiloxane, octamethylcyclotetrasiloxane, decamethylcyclopentasiloxane, dodecamethylcyclohexasiloxane, hexaethyldisiloxane, tetraethylorthosilicate, aminopropyl-trimethoxysilane, tetramethyldisiloxane, pentamethylcyclopentasiloxane, octamethylcyclooctasiloxane, vinyltrimethoxysilane, trimethoxypropylsilane, preferably hexamethyldisiloxane.

## Patentansprüche

1. Plasmavorrichtung (2) zur Aufbringung einer funktionellen Verbundschicht auf einem Substrat (4) bei Atmosphärendruck, wobei die Plasmavorrichtung eine Leitung (6) aufweist, die sich entlang einer Längsachse erstreckt, mit:
- einem Gaseinlass (8);
- einem Entladungsbereich (12), der dafür ausgelegt ist, das Gas in der Leitung (6) an dem Gaseinlass (8) elektrisch anzuregen, um ein Plasma bei Atmosphärendruck zu erzeugen;
- einem der Entladung nachgeschalteten Bereich (14), der stromabwärts von dem Entladungsbereich (12) liegt und der mindestens einen ersten, durch eine Wand der Leitung hindurch gehenden Einlass (20) umfasst, um eine erste Vorstufe oder Vorstufenmischung in das Plasma zu injizieren;
- einen Plasmaauslass (10);
wobei der der Entladung nachgeschaltete Bereich (14) ferner mindestens einen zweiten, durch die Wand der Leitung hindurch gehenden Einlass (22) umfasst, um stromabwärts von dem ersten Einlass (20) eine zweite Vorstufe oder Vorstufenmischung in das Plasma zu injizieren.

2. Plasmavorrichtung (2) nach Anspruch 1, wobei der mindestens eine erste Einlass (20) entlang der Längsachse in einem Abstand b zu dem Entladungsbereich (12) liegt, wobei der Abstand b zwischen 0 mm und 15 mm, vorzugsweise weniger als 5 mm beträgt.

3. Plasmavorrichtung (2) nach einem der Ansprüche 1 und 2, wobei der mindestens eine erste Einlass (20) und der mindestens eine zweite Einlass (22) entlang der Längsachse über einen Abstand, der zwischen 5 mm und 150 mm, vorzugsweise zwischen 5 mm und 50 mm beträgt, voneinander getrennt sind.

4. Plasmavorrichtung (2) nach einem der Ansprüche 1 bis 3, wobei die Vorrichtung dafür ausgelegt ist, eine Entladungsleistungsdichtung größer oder gleich 10 W/cm² zu produzieren.

5. Plasmavorrichtung (2) nach einem der Ansprüche 1 bis 4, wobei die Plasmavorrichtung auf einem bewegbaren Träger gelagert ist.

6. Plasmavorrichtung (2) nach einem der Ansprüche 1 bis 5, wobei sowohl der mindestens eine erste Einlass (20) als auch der mindestens eine zweite Einlass (22) jeweils dafür ausgelegt sind, die erste und die zweite Vorstufe oder Vorstufenmischung in einen Nebel und/oder ein Aerosol und/oder einen Dampf in dem der Entladung nachgeordneten Bereich zu injizieren.

7. Verfahren zur plasmaunterstützten chemischen Dampfabscheidung zum Aufbringen einer funktionellen Verbundschicht auf einem Substrat (4), wobei das Verfahren die folgenden Schritte umfasst:
- Erzeugen eines Plasmas mit einer Plasmavorrichtung (2),
- Injizieren einer ersten Vorstufe oder Vorstufenmischung in einem einer Entladung nachgeordneten Bereich (14) der Plasmavorrichtung (2);
wobei das Verfahren ferner einen Schritt des Injizierens einer zweiten Vorstufe oder Vorstufenmischung in dem der Entladung nachgeordneten Bereich (14) der Plasmavorrichtung gleichzeitig mit dem Schritt des Injizierens eines ersten Vorstufe oder Vorstufenmischung und stromabwärts von dem ersten Injizieren umfasst, wobei die Plasmavorrichtung (2) einem der Ansprüche 1 bis 6 entspricht.

8. Verfahren nach Anspruch 7, wobei die erste Vorstufe oder Vorstufenmischung eine Metalloxidvorstufe umfasst und die zweite Vorstufe oder Vorstufenmischung eine Matrixvorstufe umfasst und wobei die erste Vorstufenmischung ferner mindestens eine Metalloxiddotierungsvorstufe umfasst.

9. Verfahren nach einem der Ansprüche 7 und 8, wobei in den Schritten des Injizierens einer ersten Vorstufe oder Vorstufenmischung und einer zweiten Vorstufe oder Vorstufenmischung die erste Vorstufe oder Vorstufenmischung und die zweite Vorstufe oder Vorstufenmischung mit einer Strömungsgeschwindigkeit injiziert werden, die zwischen 1 und 1000 µl/min liegt.

10. Verfahren nach einem der Ansprüche 7 bis 9, wobei in jedem von den Schritten des Injizierens einer ersten Vorstufe oder Vorstufenmischung und einer zweiten Vorstufe oder Vorstufenmischung die Vorstufen oder Vorstufenmischungen mit einem Gasträger, vorzugsweise N₂ injiziert werden, und wobei der Gasträger vorzugsweise mit einer Strömungsgeschwindigkeit injiziert wird, die zwischen 0,5 und 20 l/min für die erste und die zweite Vorstufe oder Vorstufenmischung liegt.

11. Verfahren nach einem der Ansprüche 7 bis 10, wobei während der Aufbringung der mindestens eine Einlass (22) entlang der Längsachse in einem Abstand c, der zwischen 1 mm und 150 mm beträgt, von dem zu beschichtenden Substrat (4) platziert wird.

12. Verfahren nach einem der Ansprüche 7 bis 11, wobei sich die Plasmavorrichtung (2) während der Aufbringung relativ zu dem Substrat (4) bewegt.

13. Verfahren nach einem der Ansprüche 7 bis 12, wobei in dem Schritt des Erzeugens eines Plasmas ein Gas mit einer Strömungsgeschwindigkeit, die zwischen 10 und 100 l/min beträgt, in den Gaseinlass eingespeist wird, wobei vorzugsweise das Gas, das in den Gaseinlass (8) eingespeist wird, ausgewählt wird aus der Gruppe bestehend aus: Argon, Stickstoff, einer Argonmischung mit höchstens 20 % Sauerstoff, einer Stickstoffmischung mit höchstens 20 % Sauerstoff oder Druckluft.

14. Verfahren nach einem der Ansprüche 7 bis 13, wobei die Aufbringung bei einem Atmosphärendruck und/oder bei einer Substrattemperatur, die zwischen 50 °C und 500°C beträgt, durchgeführt wird.

15. Verfahren nach einem der Ansprüche 7 bis 14, wobei die erste Vorstufe oder Vorstufenmischung eine HO₂-Vorstufe oder eine V₂O₅-Vorstufe umfasst und/oder die zweite Vorstufe oder Vorstufenmischung eine SiO₂-Vorstufe umfasst, und
wobei die TiO₂-Vorstufe vorzugsweise ausgewählt wird aus der Gruppe bestehend aus: Titanisopropoxid, Titantetrachlorid, Titanbutoxid, Titandiisopropoxidbis(acetylacetonat) und Titanethoxid, und die SiO₂-Vorstufe ausgewählt wird aus der Gruppe bestehend aus Hexamethyldisiloxan, Hexamethylcyclotrisiloxan, Octamethylcyclotetrasiloxan, Decamethylcyclopentasiloxan, Dodecamethylcyclohexasiloxan, Hexaethyldisiloxan, Tetraethylorthosilicat, Aminopropyl-Trimethoxysilan, Tetramethyldisiloxan, Pentamethylcyclopentasiloxan, Octamethylcyclooctasiloxan, Vinyltrimethoxysilan, Trimethoxypropylsilan, vorzugsweise Hexamethyldisiloxan.

## Revendications

1. Dispositif à plasma (2) pour déposer un film composite fonctionnel sur un substrat (4) à la pression atmosphérique, ledit dispositif à plasma comprenant un conduit (6) s'étendant le long d'un axe longitudinal avec :
- une entrée de gaz (8) ;
- une zone de décharge (12) configurée pour exciter électriquement le gaz dans le conduit (6) au niveau de l'entrée (8) afin de produire un plasma à la pression atmosphérique ;
- une zone de post-décharge (14) en aval de la zone de décharge (12), comprenant au moins une première entrée (20) à travers une paroi du conduit, pour injecter un premier précurseur ou mélange de précurseurs dans le plasma ;
- une sortie de plasma (10) ;
dans lequel
la zone de post-décharge (14) comprend en outre au moins une deuxième entrée (22) à travers la paroi du conduit, pour injecter un deuxième précurseur ou mélange de précurseurs dans le plasma en aval de la au moins première entrée (20).

2. Dispositif à plasma (2) selon la revendication 1, dans lequel la au moins une première entrée (20) est située, selon l'axe longitudinal, à une distance b de la zone de décharge (12), ladite distance b étant comprise entre 0 mm et 15 mm, de préférence étant inférieure à 5 mm.

3. Dispositif à plasma (2) selon l'une quelconque des revendications 1 et 2, dans lequel la au moins une première entrée (20) et la au moins une deuxième entrée (22) sont séparées l'une de l'autre, selon l'axe longitudinal, d'une distance a comprise entre 5 mm et 150 mm, de préférence comprise entre 5 mm et 50 mm.

4. Dispositif à plasma (2) selon l'une quelconque des revendications 1 à 3, dans lequel ledit dispositif est configuré pour produire une densité de puissance de décharge supérieure ou égale à 10 W/cm².

5. Dispositif à plasma (2) selon l'une quelconque des revendications 1 à 4, dans lequel ledit dispositif à plasma est supporté par un support mobile.

6. Dispositif à plasma (2) selon l'une quelconque des revendications 1 à 5, dans lequel chacune de l'au moins une première entrée (20) et de l'au moins une deuxième entrée (22) sont respectivement configurées pour injecter les premier et deuxième précurseurs ou mélanges de précurseurs en un brouillard et/ou un aérosol et/ou une vapeur dans la zone de post-décharge.

7. Procédé de dépôt chimique en phase vapeur assisté par plasma pour déposer un film composite fonctionnel sur un substrat (4), ledit procédé comprenant les étapes consistant à :
- produire un plasma avec un dispositif à plasma (2)
- injecter un premier précurseur ou mélange de précurseurs dans une zone de post-décharge (14) dudit dispositif à plasma (2) ;
dans lequel
le procédé comprend en outre une étape d'injection d'un deuxième précurseur ou mélange de précurseurs dans ladite zone de post-décharge (14) dudit dispositif à plasma, simultanément à l'étape d'injection d'un premier précurseur ou mélange de précurseurs et en aval de la première injection, ledit dispositif à plasma (2) étant selon l'une quelconque des revendications 1 à 6.

8. Procédé selon la revendication 7, dans lequel ledit premier précurseur ou mélange de précurseurs comprend un précurseur d'oxyde métallique et en ce que ledit deuxième précurseur ou mélange de précurseurs comprend un précurseur de matrice, et, de préférence, dans lequel le premier mélange de précurseurs comprend en outre au moins un précurseur de dopage d'oxyde métallique.

9. Procédé selon l'une des revendications 7 et 8, dans lequel, dans les étapes d'injection d'un premier précurseur ou mélange de précurseurs et d'un deuxième précurseur ou mélange de précurseurs, le premier précurseur ou mélange de précurseurs et le deuxième précurseur ou mélange de précurseurs sont injectés à une vitesse d'écoulement comprise entre 1 et 1000 µL/min.

10. Procédé selon l'une quelconque des revendications 7 à 9, dans lequel, dans chacune des étapes d'injection d'un premier précurseur ou mélange de précurseurs et d'un deuxième précurseur ou mélange de précurseurs, lesdits précurseurs ou mélanges de précurseurs sont injectés avec un vecteur gazeux, de préférence N₂, et, de préférence, dans lequel le vecteur gazeux est injecté à une vitesse d'écoulement comprise entre 0,5 et 20 L/min pour le premier et le deuxième précurseur ou mélange de précurseurs.

11. Procédé selon l'une quelconque des revendications 7 à 10, dans lequel, lors du dépôt, la au moins une deuxième entrée (22) est placée, selon l'axe longitudinal, à une distance c du substrat (4) à revêtir qui est comprise entre 1 mm et 150 mm.

12. Procédé selon l'une quelconque des revendications 7 à 11, dans lequel, pendant le dépôt, le dispositif à plasma (2) se déplace par rapport au substrat (4).

13. Procédé selon l'une quelconque des revendications 7 à 12, dans lequel, à l'étape de production d'un plasma, un gaz est introduit dans l'entrée de gaz (8) à une vitesse d'écoulement comprise entre 10 et 100 L/min, de préférence dans lequel le gaz introduit dans l'entrée de gaz (8) est choisi dans le groupe constitué par l'argon, l'azote, un mélange d'argon avec un maximum de 20% d'oxygène, un mélange d'azote avec un maximum de 20% d'oxygène ou air comprimé.

14. Procédé selon l'une quelconque des revendications 7 à 13, dans lequel le dépôt est réalisé à la pression atmosphérique et/ou à une température du substrat comprise entre 50°C et 500°C.

15. Procédé selon l'une quelconque des revendications 7 à 14, dans lequel le premier précurseur ou mélange de précurseurs comprend un précurseur de TiO₂ ou un précurseur de V₂O₅ et/ou le deuxième précurseur ou mélange de précurseurs comprend un précurseur de SiO₂, et, de préférence, dans lequel le précurseur de TiO₂ est choisi dans le groupe constitué par l'isopropoxyde de titane, le tétrachlorure de titane, le butoxyde de titane, le diisopropoxyde de titane bis (acétylacétonate) et l'éthoxyde de titane et le précurseur de SiO₂ est choisi dans le groupe constitué par l'hexaméthyldisiloxane, l'hexaméthylcyclotrisiloxane, l'octaméthylcyclotétrasiloxane, le décaméthylcyclopentasiloxane, le dodécaméthylcyclohexasiloxane, l'hexaéthyldisiloxane, le tétraéthylorthosilicate, l'aminopropyl-triméthoxysilane, le tétraméthyldisiloxane, le pentaméthylcyclopentasiloxane, l'octaméthylcyclooctasiloxane, le vinyltriméthoxysilane, le triméthoxypropylsilane, de préférence l'hexaméthyldisiloxane.
